# EUROPEAN PATENT SPECIFICATION

(11) **EP 1 887 101 B1**
(45) Date of publication and mention of the grant of the patent: **23.11.2016**
(21) Application number: 07113500.8
(22) Date of filing: 31.07.2007
(51) Int. Cl.: C03C 17/00, B23K 35/26

(54) **Production method for tin targets used in magnetron sputtering coating of glass**
Produktionsmethode für Zinnziele, die in der Magnetronsputternbeschichtung von Glas benutzt wird
Méthode de production de cibles en étain utilisées dans le revêtement de substats en verre par pulvérisation magnétron.

(30) Priority: 31.07.2006 TR 200604005
(43) Date of publication of application: 13.02.2008
(73) Proprietor: TUBITAK-Turkiye Bilimsel ve Teknolojik Arastirma Kurumu, 06100 Ankara (TR)
(72) Inventor: Kaya, Ali Arslan, 41470 Kocaeli (TR)

(56) References cited:
- EP-A- 0 787 818
- US-A- 5 066 381

## Description

### FIELD OF THE INVENTION

This invention describes a new method to be used in manufacturing copper-tin couples known as 'target' made of a copper plate bearing metallurgically bonded a tin slab, of which tin is consumed while being used in tin oxide (SnO) coating on glass via 'magnetron sputtering' technique.

### BACKROUND OF THE ART

In today's technique, as being same with the cited document EP-A-0 787 818, the manufacturing of the said 'target' metal couples is either achieved by casting the tin on a copper slab and solidifying it there, or by manually spreading a liquefied alloy of low melting such as indium-bismuth onto the necessary bonding area on the heated copper piece and afterwards placing the tin on that area thus forming a metallurgical bonding between the two metals. Both methods, still being commercially used, differs from the proposed method here as described under the 'Detailed description of the invention'.

The document EP-A-0 787 818 specifically presents one particular method of application for binding alloys regardless of their composition. This suggested method of application of the binding agent is via a piece of cloth and/or metallic brush. EP-A-0 787 818 document states the use of mainly three different type of binding alloy compositions of low melting temperature, i.e. Bi-Sn, Bi-Sn-In-Cu and In-Sn systems without expressing the possibility of a wide variety of compositions within these alloy systems, or the possibility of using the binding alloy in the foil form. EP-A-0 787 818 document makes no reference to the health issues involved in manual application of such molten metallic alloys in a time consuming and a rather crude way. Nor does EP-A-0 787 818 document expresses any concern in terms of the homogeneity of the binding alloy thickness applied to the surfaces.

The document US-A-5 066 381 describes a new design method to remove the used sections and thus reclaim the consumable parts of magnetron sputtering targets. The solution suggested focuses on the multi-section design of the magnetron sputtering targets as opposed to a monolithic design that, in a way, offers more economical use of the consumable part of a target assembly.

### DETAILED DESCRIPTION OF THE INVENTION

The method proposed here is based on placing a foil made of an indium-tin alloy between the copper and tin slabs and forming a metallurgical bond at temperatures where this binding agent alloy melts. By using a foil of indium-tin alloy instead of molten indium alone a homogeneous quantity of binding agent can be employed at the interface, an economic saving achieved due to reduction of use of pure indium, and lesser diffusion of indium as a contaminant into the tin side of the copper-tin couple that is to be used in coating glass thus reducing the contamination in the tin oxide coating itself. Since the tin contamination is reduced, the contamination of the unconsumed scrap portion of the tin slab that is machined off the copper surface, as the tin slab cannot be exhausted entirely in the process, is also reduced.

The necessary configuration of the slabs of copper and tin, and indium-tin alloy foil for bonding proposed by this invention is given in the annexed drawing, of which:

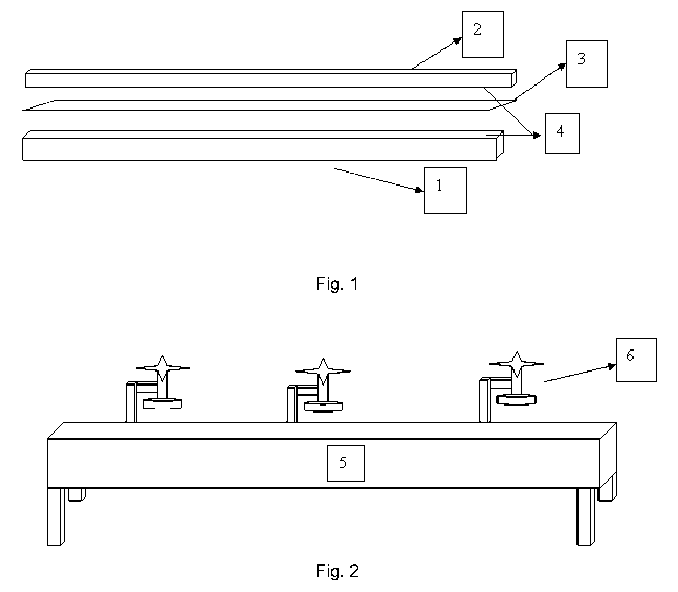

Figure 1- Schematic appearance of target parts.
Figure 2- Schematic appearance of the heating table that is necessary to form metallurgical bonding between tin and copper under compression.

The copper and tin slabs to be bonded can be produced initially via casting and then be subjected to surface machining. Alternatively they can be purchased in the required form and dimensions and then be subjected to bonding process. The surfaces to be bonded should be better prepared than the others via a finer machining. A soldering paste that is commonly available in the market should be manually applied to the surfaces to be bonded as a thin layer. The foil prepared from indium-tin alloy is then laid onto the surface of the copper slab to be bonded. The tin slab with soldering paste already applied to its bonding surface is then placed on top of the copper slab that is covered with the foil. This assembly of metallic couples is then carried onto the already hot heating table. The slabs are pressed together by using the screws on the heating table. The squeezing of the slabs together is achieved by using as many screws as possible. The stress applied at any one of the screw positions is between 2Kg/cm² and 25 Kg/cm². The level of stress to be applied depends on the foil thickness selected and the temperature of diffusion bonding. If thicker foil and higher temperatures are employed the stress applied may be kept low, otherwise higher levels are preferred. The maximum temperature of heating, as measured at the copper-tin interface, should be between 150-225°C and the duration of heating, depending on the temperature selected, between 1 to 20 hours. The period of heating can be shortened as the temperature selected increases and vice versa.

As the heating time progresses the indium-tin alloy foil placed between the copper and tin slabs will melt first and then start hardening as an intermetallic compound forms. This phenomenon indicates the completion of the process and within 1 to 6 hours following this observation the heating may be switched off (this period is included in the total heating times mentioned above). The cooling must be done naturally on the heating table. No extra cooling procedure should be applied.

The composition of the indium-tin foil used in this process should be selected between 5% to 95% indium (balance tin) and prepared in a ceramic or carbon crucible. The melting temperature of the foil must be lower than that of the tin. Thus the composition of the foil should be selected also with regard to the maximum heating temperature preferred. If bonding is to be done at higher temperatures the indium content of the foil can be close to 5% level, otherwise, that is for lower temperatures, a ratio closer to 90% levels is selected. The minimum temperature for bonding on the heating table is finally set by the melting temperature of the foil alloy as indicated on the In-Sn binary phase diagram. The indium-tin alloy prepared by melting is suitable for rolling and can be subjected to cold rolling. The thickness of the indium-tin alloy foil that will act as bonding agent between copper and tin slabs can be between 50 and 150 micron.

Since indium metal is relatively expensive the foil thickness may be preferred thin. However, the chosen foil thickness also depends on the bonding temperature to be employed. Thinner foils are preferred for higher bonding temperatures and vice versa.

When the process of forming a metallurgical bond is completed following the melting and transformation of the foil between the copper and tin slabs into an intermetallic compound while on the heating table the slab of copper-tin couple is transferred to machining operation for final surface preparation and to give other geometric modifications later necessary for the connections at the site of service. Having done the surface preparations via machining the 'target' is ready for delivery to be used in 'magnetron sputtering' process.

### EXPLANATIONS OF THE FIGURES

1) Copper slab
2) Tin slab
3) indium-tin alloy foil
4) Thin layer of soldering paste applied onto the bonding surface of copper slab and tin slab.
5) Heating table used for heating the slabs to form metallurgical bonding.
6) The screw mandrels used to compress the copper and tin slabs together while on the heating table.

## Claims

1. A method for manufacturing copper-tin slab couples known as 'target' made of a copper plate bearing metallurgically bonded a tin slab, of which tin is consumed while being used in tin oxide (SnO) coating on glass via 'magnetron sputtering' technique, **characterized in that** joining of copper and tin slabs/plates is achieved by employing at their interface an indium-tin alloy foil having a lower melting temperature than tin, and creating a metallurgical bonding through diffusion under the necessary set of temperature, time and load parameters.

2. A method for manufacturing copper-tin slab couples which is used in coating glass surfaces with tin oxide (SnO) via 'magnetron sputtering' technique according to Claim 1, charecterized in that the parameters of creating metallurgical bonding by melting at the interface of copper and tin pieces an indium-tin alloy foil at lower melting temperature than tin are as follows:
Temperature: 150 to 225°C;
Stress applied at each screw: 2Kg/cm² to 25 Kg/cm²,
Time of heating: 1 to 20 hours;
Foil composition: 5 weight % to 95 weight % indiyum (bal. tin)
Foil thickness: 50 to 150 micron

## Patentansprüche

1. Inden mit Technik der "Magnetron Einspritzung" bei Beschichtung der Glasscheibe mit Zinnoxid (SnO) angewendet wird, ist das Methode für Herstellung des Schildes aus Kupfer-Zinn, das als "Ziel" bekannt, das aus dem Kupferplatte, die dem Zinnschild beinhaltet, erzeugt, der als Metallurgisch angeschlossen ist, in der das Zinn verbraucht wird, ist die Mischung der Folie aus Legierung der Indium-Zinn, die durch Mischung der Schildern/Platten aus Kupfer und Zinn der niedrigen Verschmelzungstemperatur als Zinn hat, auf dien Schnittstellen anwendend zu schaffen ist, und die erforderliche Temperaturzüge anhand der Diffusion unter Parametern der Zeit und Belastung die Metallurgische Anschluss anschaffend charakterisiert.

2. Methode der Herstellung von Schildpaaren aus Kupfer-Zinn, die nach Ansprüche 1 mit Technik der "Magnetron Einspritzung" bei Beschichtung der Oberfläche der Glasscheiben mit Zinnoxid (SnO) verwendet, sind die in Schnittstelle der Legierung aus Indium-Zinn der Bestandteilen der Kupfer und Zinn verschmelzend bei niedrigeren Verschmelzungstemperatur als Zinn besonderen Parametern, die bei Schaffung des Metallurgischen Anschlusses charakterisiert wurden:
Temperatur: 150 sowie 225°C;
Bei jeder Schraube ausgeübter Druck: 2Kg/cm2 sowie 25 Kg/cm2,
Aufwärmungsdauer: 1 sowie 20 Stunden,
Bildung der Folie: 5 Gewicht % sowie 95 Gewicht % Indium (bal. Zinn)
Dicke der Folie: 50 sowie 150 Mikron

## Revendications

1. Méthode pour la fabrication de la plaque en cuivre-étain connue comme "cible" réalisée de la plaque en cuivre comportant la plaque en étain liée métalliquement dont on a consommé le cuivre en utilisant pour le revêtement avec de l'oxyde d'étain (SnO) du verre avec la technique de "pulvérisation de magnéton", caractérisée avec la création de la liaison métallurgique par l'intermédiaire de la diffusion sous les paramètres de changement, de temps et de la série de température nécessaire et avec la réussite en appliquant aux interfaces de la feuille d'alliage d'indium-étain ayant la température de fusion plus basse que l'étain dont la l'union des plaques/dalles en cuivre et en étain.

2. Selon la revendication 1, méthode pour la fabrication des paires de plaque en cuivre-étain utilisé pour le revêtement avec l'oxyde d'étain (SnO) des surfaces en verre avec la technique de "pulvérisation de magnétron", les paramètres qui sont caractérisés pour la création de la liaison métallurgique avec la fusion à l'interface d'alliage d'indium-étain des particules de cuivre et d'étain à la température plus basse que l'étain :
Température: de 150 à 225°C;
Pression exercée sur chaque vis: de 2Kg/cm2 à 25 Kg/cm2,
Délai de chauffage: de 1 à 20 heures;
Structure de feuille: avec 5 poids % 95 poids % indium (cuivre étain)
Epaisseur de feuille : de 50 à 150 microns
